# EUROPÄISCHE PATENTSCHRIFT

(11) **EP 3 799 534 B1**
(45) Veröffentlichungstag und Bekanntmachung des Hinweises auf die Patenterteilung: **15.05.2024**
(21) Anmeldenummer: 20175403.3
(22) Anmeldetag: 19.05.2020
(51) Int. Cl.: H05B 47/19, H02G 3/12, H05K 5/00, H02G 3/08, H01H 23/04, H01H 3/12, H01H 21/04

(54) **FUNKTIONSMODUL**
FUNCTIONAL MODULE
MODULE FONCTIONNEL

(30) Priorität: 24.09.2019 DE 202019105275 U
(43) Veröffentlichungstag der Anmeldung: 31.03.2021
(73) Patentinhaber: Insta GmbH, 58509 Lüdenscheid (DE)
(72) Erfinder: Müller, Tobias, 58566 Kierspe (DE); Steins, Stephan, 44149 Dortmund (DE); Sangermann, Marc, 44229 Dortmund (DE); Neuhaus, Stefan, 44289 Dortmund (DE)
(74) Vertreter: Fobbe, Tobias

(56) Entgegenhaltungen:
- US-A1- 2006 097 890
- US-A1- 2010 314 226
- US-A1- 2015 359 075

## Beschreibung

Die vorliegende Erfindung geht von einem gemäß Oberbegriff des Hauptanspruches konzipierten Funktionsmodul aus.

Derartige Funktionsmodule für elektrische/elektronische Schaltgeräte der Gebäudeinstallationstechnik sind in der Regel dafür vorgesehen, über ihre unabhängigen Kanäle Telegramme auszusenden, wobei die Telegramme zur Ansteuerung verschiedener Aktoren und/oder Sensoren Verwendung finden. Derartige Funktionsmodule werden oftmals als Tasterschnittstelle bezeichnet und verfügen beispielsweise über zwei oder vier unabhängige Kanäle. So kann die Tasterschnittstelle potentialfrei bis zu vier Taster-/Schalterzustände bei gemeinsamen Bezugspotential einlesen und dementsprechend Telegramme beispielsweise auf ein Bussystem aussenden. Das können Telegramme zum Schalten oder Dimmen, zur Jalousiesteuerung oder Wertgeberanwendung (Dimmwertgeber, Lichtszenennebenstelle, Temperatur- oder Helligkeitswertgeber) sein. Weiterhin können zwei Schaltzähler oder zwei Impulszähler zur Verfügung stehen.

Ein dem Oberbegriff des Hauptanspruches entsprechendes Funktionsmodul ist somit aus dem Stand der Technik bekannt. Ein solches Funktionsmodul ist für die Gebäudeinstallationstechnik ausgelegt und weist ein aus einem Sockelteil und einem Deckelteil bestehendes Gehäuse auf, in dessen Innenraum auf zumindest einer elektrischen Leiterplatte die zur Funktion notwendige elektrische/elektronische Bauteile untergebracht sind. Die elektrische Leiterplatte steht mit mehreren Anschlusskabeln zur Bildung einer Schnittstelle in Verbindung, über welche der Anschluss eines elektrischen/elektronischen Schaltgerätes erfolgt. Über mehrere unabhängige Kanäle können mittels Funksignale Telegramme ausgesendet werden, wobei die Telegramme zur Ansteuerung verschiedener Aktoren und/oder Sensoren Verwendung finden. Zu einer direkten Beeinflussung durch einen Benutzer mittels eines Betätigungselementes eines zugeordneten Oberteils eines elektrischen/elektronischen Schaltgerätes ohne Zwischenschaltung einer Leitungsverbindung sind derartige Funktionsmodule nicht geeignet.

Aus US 2010/0314226 A1 ist ein elektrisches/elektronisches Schaltgerät bekannt, welches zwei Schalter, ein Gehäuse sowie ein zumindest teilweise in dem Gehäuse gelagertes Funktionsmodul aufweist. Durch dieses Funktionsmodul können drahtlose Signale zur Steuerung einer elektrischen/elektronischen Last abgesetzt werden, so dass neben einer direkten Steuerung auch eine Remote-Steuerung einer elektrischen/elektronischen Last möglich wird.

US 2006/0097890 A1 offenbart einen Drei-Wege-Lichtschalter umfassend ein Funktionsmodul mit einem Sender-Lichtschalter, der elektrisch an einen Empfänger-Lichtschalter angeschlossen ist, wobei der Sender-Lichtschalter dazu ausgebildet ist, eine Adresse und ein Datensignal an den Empfänger-Lichtschalter zu senden, wobei dieser dann als Master-Controller für die angeschlossene elektrische/elektronische Last fungiert. Dabei weisen sowohl der Sender als auch der Empfänger-Lichtschalter einen Ein-/Ausschaltschalter und einen Dimmschalter auf. Bei Betätigung des Ein- oder Ausschalters oder des Dimmschalters sendet der Sender-Lichtschalter ein entsprechendes Funk-Signal an den Empfänger-Lichtschalter, welcher das Signal empfängt und dekodiert, und über eine direkte elektrische Steuerung eine Leuchte schaltet bzw. dimmt.

Aus US 2015/0359075 A1 ist ein elektrisches/elektronisches Schaltgerät bekannt, das ein Gehäuse sowie ein in dem Gehäuse gelagertes Funktionsmodul aufweist. Dabei ist zur abschirmungsminimierten drahtlosen Schaltung einer elektrischen/elektronischen Last eine Sender-Antenne vorgesehen, die durch das Gehäuse des Schaltgerätes hindurchgreift und ein Signal an einen Empfänger absetzt, wodurch ein fernbedienbarer drahtloser Schalter realisiert wird.

Ausgehend von einem derartigen Funktionsmodul liegt der vorliegenden Erfindung die Aufgabe zugrunde, ein Funktionsmodul zu schaffen, welches auf einfache Art und Weise mittels eines Betätigungselementes eines zugeordneten Oberteils eines elektrischen/elektronischen Schaltgerätes direkt vom Benutzer beeinflusst werden kann, ohne dass die Zwischenschaltung einer Leitungsverbindung notwendig ist, wobei dem Benutzer auf einfache und kostengünstige Art und Weise zusätzliche Bedienmöglichkeiten zur Verfügung gestellt werden.

Erfindungsgemäß wird diese Aufgabe durch die im Hauptanspruch angegebenen Merkmale gelöst.

Bei einer solchen Ausbildung ist besonders vorteilhaft, dass dem Benutzer auf einfache und kostengünstige Art und Weise zusätzliche Bedienmöglichkeiten zur Verfügung gestellt werden.

Weitere vorteilhafte Ausgestaltungen des erfindungsgemäßen Gegenstandes sind in den Unteransprüchen angegeben. Anhand eines Ausführungsbeispiels sei die Erfindung im Prinzip näher erläutert, dabei zeigen:
- Fig. 1:: prinziphaft ein aus einem Funktionsmodul, einem Oberteil und einem Designrahmen bestehendes elektrisches/elektronisches Schaltgerät, räumlich, in Explosionsdarstellung;
- Fig. 2:: prinziphaft das Funktionsmodul gemäß Figur 1, räumlich, in Explosionsdarstellung;
- Fig. 3:: prinziphaft das Oberteil gemäß Figur 1, räumlich, in Unteransicht.

Wie aus den Figuren hervorgeht, weist ein solches Funktionsmodul F für ein elektrisches/elektronisches Schaltgerät S der Gebäudeinstallationstechnik ein aus einem Sockelteil 1 und einem Deckelteil 2 bestehendes Gehäuse auf. In dessen Innenraum 4 sind auf einer elektrischen Leiterplatte 5 die zur Funktion notwendigen elektrischen/elektronischen Bauteile 6 untergebracht, mittels welcher mehrere unabhängige Kanäle zur Verfügung gestellt werden. Über die Kanäle werden mittels Funksignale Telegramme ausgesendet, wobei die Telegramme zur Ansteuerung verschiedener Aktoren und/oder Sensoren Verwendung finden. Über die Telegramme können die Aktoren und/oder Sensoren direkt angesprochen werden.

Es ist jedoch durchaus möglich, dies über ein Bussystem vorzunehmen. Die elektrische Leiterplatte 5 weist zudem zum Anschluss mehrerer elektrischer Leitungen 7 eine Schnittstelle 8 auf. Außerdem sind auf der elektrischen Leiterplatte 5 zwei Schaltelemente 9 angeordnet, welche mittels je eines zugeordneten Betätigungselementes 10 eines zugeordneten Oberteils 11 des elektrischen/elektronischen Schaltgerätes S zur Aussendung von Telegrammen direkt beeinflussbar sind.

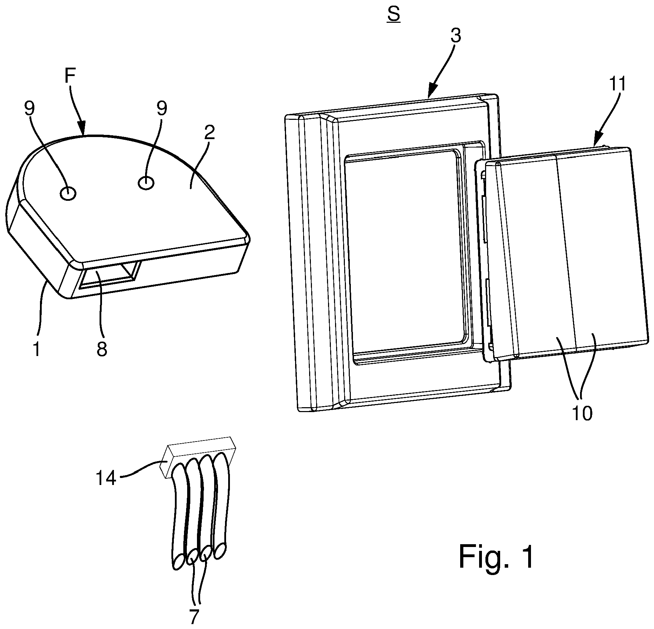

Wie insbesondere aus Figur 1 hervorgeht, weist das elektrische Schaltgerät S beim vorliegenden Ausführungsbeispiel einen Designrahmen 3 auf, welcher das Oberteil 11 des elektrischen/elektronischen Schaltgerätes S aufnimmt beziehungsweise umgibt. Das elektrische/elektronische Schaltgerät S besteht also aus dem Funktionsmodul F, dem Oberteil 11 und dem Designrahmen 3. Das elektrische/elektronische Schaltgerät S ist zur direkten Wandmontage vorgesehen, kann aber ohne weiteres auch unter Zuhilfenahme einer, der Einfachheit halber nicht dargestellten, Installationsdose montiert werden. Auch eine Benutzung als mobile Fernbedienung ist durchaus möglich. Wie des Weiteren insbesondere aus Figur 1 hervorgeht, ist die Schnittstelle 8 der elektrischen Leiterplatte 5 als Steckeranschluss ausgeführt und dazu vorgesehen, mit vier elektrischen Leitungen 7 verbunden zu werden. Die vier elektrischen Leitungen 7 sind zu diesem Zweck an einem Stecker 14 angeschlossen. Um eine funktionsgerechte Befestigung des Funktionsmoduls F am Oberteil 11 zu realisieren, weist dieses einen auf die Außenabmessungen des Funktionsmoduls F maßlich abgestimmten Aufnahmeraum 17 auf.

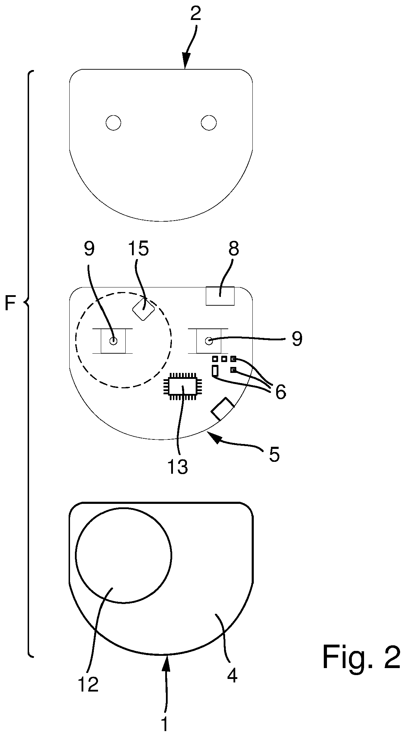

Wie insbesondere aus Figur 2 hervorgeht, besteht das Gehäuse des Funktionsmodul F, wie bereits beschrieben, aus einem Sockelteil 1 und einem Deckelteil 2. Im Innenraum 4 des Gehäuses ist die Leiterplatte 5 aufgenommen, welche beidseitig mit elektrischen/elektronischen Bauteilen 6 bestückt ist. Zudem ist, wie bereits beschrieben, die Schnittstelle 8 an der elektrischen Leiterplatte 5 vorhanden. Zur Erzeugung der Telegramme ist zudem ein Funkmodul 13 auf der elektrischen Leiterplatte 5 angeordnet. Zur Kontaktierung einer Batterie 12 sind Batteriekontakte 15 vorgesehen. Die Batterie 12 versorgt das Funktionsmodul F mit der zum Betrieb notwendigen Energie.

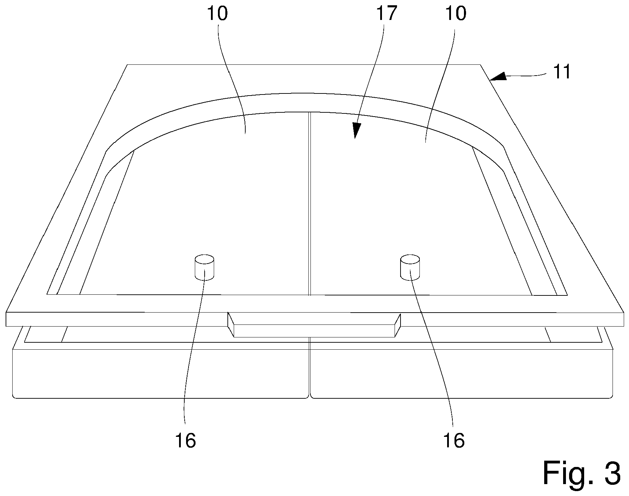

Wie insbesondere aus den Figuren 1 und 3 hervorgeht, ist das Oberteil 11 des elektrischen/elektronischen Schaltgerätes S einstückig ausgeführt und weist zwei Betätigungselemente 10 auf, die je als einseitig angebundene Schaltwippe ausgeführt sind. Wie insbesondere aus Figur 3 hervorgeht, ist jedes der beiden Betätigungselemente 10 mit einer Schaltnocke 16 versehen, welche direkt mit dem zugeordneten Schaltelement 9 des Funktionsmoduls F zusammenwirkt. Wie bereits beschrieben, ist zur funktionsgerechten Befestigung des Funktionsmoduls F am Oberteil 11 ein auf die Außenabmessungen des Funktionsmoduls F maßlich abgestimmter Aufnahmeraum 17 vorgesehen. Der Aufnahmeraum 17 ist dabei derart gestaltet, sodass das Funktionsmodul F wandbündig aufgenommen wird.

Die Schnittstelle 8 kann, wie auch beim Stand der Technik vorgesehen, über die elektrischen Leitungen 7 zum Anschluss eines weiteren elektrischen/elektronischen Schaltgerätes (der Einfachheit halber nicht dargestellt) genutzt werden. Es besteht somit die Möglichkeit, lediglich das weitere elektrische/elektronische Schaltgerät (der Einfachheit halber nicht dargestellt) mit dem Funktionsmodul F über die elektrischen Leitungen 7 zu verbinden, damit bei dessen Betätigung über das Funktionsmodul F entsprechende Telegramme ausgesendet werden. Die beiden Schaltelemente 9 bleiben dann ungenutzt. Erfindungsgemäß ist zudem vorgesehen, dem Funktionsmodul F, wie bereits beschrieben, zur direkten Beeinflussung seiner beiden Schaltelemente 9 ein Oberteil 11 des elektrischen/elektronischen Schaltgerätes S zuzuordnen und zusätzlich über die elektrischen Leitungen 7 im Sinne einer Nebenstelle ein weiteres elektrisches/elektronisches Schaltgerät (der Einfachheit halber nicht dargestellt) an das Funktionsmodul F anzubinden.

Es ist somit ein Funktionsmodul F geschaffen, welches auf einfache Art und Weise mittels mehrerer Betätigungselemente 10 des zugeordneten Oberteils 11 des elektrischen/elektronischen Schaltgerätes S direkt vom Benutzer beeinflusst werden kann, ohne dass die Zwischenschaltung einer Leitungsverbindung notwendig ist. Vorteilhafterweise werden dem Benutzer auf einfache und kostengünstige Art und Weise zusätzliche Bedienmöglichkeiten zur Verfügung gestellt.

### Bezugszeichenliste-.

- 1: Sockelteil
- 2: Deckelteil
- 3: Designrahmen
- 4: Innenraum
- 5: elektrische Leiterplatte
- 6: elektrische/elektronische Bauteile
- 7: elektrische Leitungen
- 8: Schnittstelle
- 9: Schaltelemente
- 10: Betätigungselemente
- 11: Oberteil
- 12: Batterie
- 13: Funkmodul
- 14: Stecker
- 15: Batteriekontakte
- 16: Schaltnocke
- 17: Aufnahmeraum
- F: Funktionsmodul
- S: elektrisches/elektronisches Schaltgerät

## Patentansprüche

1. Funktionsmodul (F) für ein elektrisches/elektronisches Schaltgerät (S) der Gebäudeinstallationstechnik, wobei das Funktionsmodul (F) ein aus einem Sockelteil (1) und einem Deckelteil (2) bestehendes Gehäuse aufweist, in dessen Innenraum (4) auf zumindest einer elektrischen Leiterplatte (5) zur Funktion notwendige elektrische/elektronische Bauteile (6) untergebracht sind, mittels welcher mehrere unabhängige Kanäle zur Aussendung von Telegrammen mittels Funksignalen zur Verfügung gestellt werden, wobei die Telegramme zur Ansteuerung verschiedener Aktoren und/oder Sensoren verwendbar sind und wobei die zumindest eine elektrische Leiterplatte (5) zum Anschluss mehrerer elektrischer Leitungen (7) zumindest eine Schnittstelle (8) aufweist, wobei auf der zumindest einen elektrischen Leiterplatte (5) zumindest ein Schaltelement (9) vorgesehen ist, welches mittels eines zugeordneten Betätigungselementes (10) eines zugeordneten Oberteils (11) des elektrischen/elektronischen Schaltgerätes (S) zur Aussendung von Telegrammen direkt beeinflussbar ist, **dadurch gekennzeichnet, dass** die zumindest eine Schnittstelle (8) einen Anbindungspunkt für ein weiteres elektrisches/elektronisches Schaltgerät an das Funktionsmodul (F) im Sinne einer Nebenstelle bereitstellt, damit bei einer Betätigung des weiteren elektrischen/elektronischen Schaltgerätes über das Funktionsmodul (F) entsprechende Telegramme ausgesendet werden.

2. Funktionsmodul nach Anspruch 1, **dadurch gekennzeichnet, dass** auf der zumindest einen elektrischen Leiterplatte (5) mehrere Schaltelemente (9) vorgesehen sind, welche mittels des zugeordneten Betätigungselementes (10) des Oberteils (11) des elektrischen/elektronischen Schaltgerätes (S) direkt beeinflussbar sind.

3. Funktionsmodul nach einem der Ansprüche 1 bis 2, **dadurch gekennzeichnet, dass** der zumindest einen elektrischen Leiterplatte (5) zur Versorgung mit der zum Betrieb notwendigen Energie eine Batterie (12) zugeordnet ist.

4. Funktionsmodul nach einem der Ansprüche 1 bis 2, **dadurch gekennzeichnet, dass** die zumindest eine elektrische Leiterplatte (5) zur Versorgung mit der zum Betrieb notwendigen Energie an das Installationsnetz des Gebäudes anschließbar ist.

5. Funktionsmodul nach einem der Ansprüche 1 bis 4, **dadurch gekennzeichnet, dass** die zumindest eine Schnittstelle (8) der zumindest einen elektrischen Leiterplatte (5) als Steckeranschluss ausgeführt ist.

6. Funktionsmodul nach einem der Ansprüche 1 bis 5, **dadurch gekennzeichnet, dass** die zumindest eine elektrische Leiterplatte (5) mit zumindest einem Funkmodul (13) bestückt ist.

7. Funktionsmodul nach einem der Ansprüche 1 bis 6, **dadurch gekennzeichnet, dass** die elektrische Leiterplatte (5) beidseitig mit den elektrischen/elektronischen Bauteilen (6) bestückt ist.

## Claims

1. Functional module (F) for an electrical/electronic switching device (S) for building installation technology, wherein the functional module (F) has a housing consisting of a base part (1) and a cover part (2), in the interior (4) of which electrical/electronic components (6) necessary for the function are accommodated on at least one electrical printed circuit board (5), by means of which a plurality of independent channels for transmitting telegrams by means of radio signals are made available, wherein the telegrams can be used to control various actuators and/or sensors and wherein the at least one electrical printed circuit board (5) has at least one interface (8) for connecting a plurality of electrical lines (7), wherein at least one switching element (9) is provided on the at least one electrical printed circuit board (5), which switching element can be directly influenced by means of an associated actuating element (10) of an associated upper part (11) of the electrical/electronic switching device (S) for transmitting telegrams, **characterised in that** the at least one interface (8) provides a connection point for a further electrical/electronic switching device to the functional module (F) in the sense of an extension, so that corresponding telegrams are transmitted via the functional module (F) when the further electrical/electronic switching device is actuated.

2. Functional module according to claim 1, **characterised in that** several switching elements (9) are provided on the at least one electrical printed circuit board (5), which switching elements can be directly influenced by means of the associated actuating element (10) of the upper part (11) of the electrical/electronic switching device (S).

3. Functional module according to any of claims 1 to 2, **characterised in that** a battery (12) is associated with the at least one electrical printed circuit board (5) for supplying the energy required for operation.

4. Functional module according to any of claims 1 to 2, **characterised in that** the at least one electrical printed circuit board (5) can be connected to the installation network of the building to be supplied with the energy required for operation.

5. Functional module according to any of claims 1 to 4, **characterised in that** the at least one interface (8) of the at least one electrical printed circuit board (5) is designed as a plug connection.

6. Functional module according to any of claims 1 to 5, **characterised in that** the at least one electrical printed circuit board (5) is equipped with at least one radio module (13).

7. Functional module according to any of claims 1 to 6, **characterised in that** the electrical printed circuit board (5) is fitted with the electrical/electronic components (6) on both sides.

## Revendications

1. Module fonctionnel (F) pour un appareil de commutation électrique/électronique (S) de la technique d'installation de bâtiments, le module fonctionnel (F) présentant un boîtier constitué d'une partie de socle (1) et d'une partie de couvercle (2), dans l'espace intérieur (4) duquel des composants électriques/électroniques (6) nécessaires au fonctionnement sont logés sur au moins une carte de circuit imprimée électrique (5), au moyen desquels plusieurs canaux indépendants sont mis à disposition pour l'émission de télégrammes au moyen de signaux radio, les télégrammes pouvant être utilisés pour la commande de différents actionneurs et/ou capteurs et l'au moins une carte de circuit imprimé électrique (5) présentant au moins une interface (8) pour le raccordement de plusieurs lignes électriques (7), au moins un élément de commutation (9) étant prévu sur l'au moins une carte de circuit imprimé électrique (5), lequel peut être influencé directement au moyen d'un élément d'actionnement associé (10) d'une partie supérieure associée (11) de l'appareil de commutation électrique/électronique (S) pour l'émission de télégrammes, **caractérisé en ce que** l'au moins une interface (8) met à disposition un point de connexion pour un autre appareil de commutation électrique/électronique au module fonctionnel (F) dans le sens d'un poste secondaire, afin que, lors d'un actionnement de l'autre appareil de commutation électrique/électronique, des télégrammes correspondants soient émis par l'intermédiaire du module fonctionnel (F).

2. Module fonctionnel selon la revendication 1, **caractérisé en ce que** plusieurs éléments de commutation (9) sont prévus sur l'au moins une carte de circuit imprimé électrique (5), lesquels peuvent être influencés directement au moyen de l'élément d'actionnement (10) associé de la partie supérieure (11) de l'appareil de commutation électrique/électronique (S).

3. Module fonctionnel selon l'une quelconque des revendications 1 à 2, **caractérisé en ce qu'**une batterie (12) est associée à l'au moins une carte de circuit imprimé électrique (5) pour l'alimentation en énergie nécessaire au fonctionnement.

4. Module fonctionnel selon l'une quelconque des revendications 1 à 2, **caractérisé en ce que** l'au moins une carte de circuit imprimé électrique (5) peut être raccordée au réseau d'installation du bâtiment pour l'alimentation en énergie nécessaire au fonctionnement.

5. Module fonctionnel selon l'une quelconque des revendications 1 à 4, **caractérisé en ce que** l'au moins une interface (8) de l'au moins une carte de circuit imprimé électrique (5) est réalisée sous la forme d'une connexion à fiche.

6. Module fonctionnel selon l'une quelconque des revendications 1 à 5, **caractérisé en ce que** l'au moins une carte de circuit imprimé électrique (5) est équipée d'au moins un module radio (13).

7. Module fonctionnel selon l'une quelconque des revendications 1 à 6, **caractérisé en ce que** la carte de circuit imprimé électrique (5) est équipée des deux côtés des composants électriques/électroniques (6).
